# EUROPÄISCHE PATENTSCHRIFT

(11) **EP 2 153 489 B1**
(45) Veröffentlichungstag und Bekanntmachung des Hinweises auf die Patenterteilung: **18.07.2012**
(21) Anmeldenummer: 08760023.5
(22) Anmeldetag: 26.05.2008
(51) Int. Cl.: H01P 11/00, H03K 3/53, H05B 41/04

(54) **VERFAHREN ZUR HERSTELLUNG EINES KERAMISCHEN SPIRAL-PULS-GENERATORS SOWIE KERAMISCHER SPIRAL-PULS-GENERATOR**
METHOD FOR THE PRODUCTION OF A CERAMIC SPIRAL PULSE GENERATOR AND CERAMIC SPIRAL PULSE GENERATOR
PROCÉDÉ POUR PRODUIRE UN GÉNÉRATEUR D'IMPULSIONS CÉRAMIQUE EN SPIRALE ET GÉNÉRATEUR D'IMPULSIONS CÉRAMIQUE EN SPIRALE AINSI OBTENU

(30) Priorität: 06.06.2007 DE 102007026306
(43) Veröffentlichungstag der Anmeldung: 17.02.2010
(73) Patentinhaber: OSRAM AG, 81536 München (DE)
(72) Erfinder: GRÄF, Jürgen, 86163 Augsburg (DE); WALTER, Steffen, 85667 Oberpframmern (DE); KLOSS, Andreas, 85579 Neubiberg (DE)
(86) Internationale Anmeldenummer: PCT/EP2008/056424
(87) Internationale Veröffentlichungsnummer: WO 2008/148657

(56) Entgegenhaltungen:
- JP-A- 1 096 911
- JP-A- 2005 033 579
- US-A- 4 353 012
- US-A1- 2003 118 481
- US-A1- 2003 128 082

## Beschreibung

### Technisches Gebiet

Der Spiral-Puls-Generator ist ein Bauteil, das Eigenschaften eines Kondensators mit denen eines Wellenleiters zur Erzeugung von Zündpulsen mit einer Spannung von mindestens 1,5 kV vereint. Mit den erfindungsgemäßen Herstellverfahren können Spiral-Puls-Generatoren erzeugt werden, die je nach Material bis ca. 500°C, 700°C bzw. 1000°C temperaturbeständig sind. Der Spiral-Puls-Generator ist als LTCC- oder HTCC-Bauteil ausgeführt und besteht im wesentlichen aus Keramikfolien und metallischer Leitpaste bzw. einer metallischen Folie, die zu einer Schnecke gewickelt und dann laminiert sowie gesintert werden.

Spiral Puls Generatoren können als Zündtransformatoren für Entladungslampen verwendet werden. Bei dieser Anwendung ist vor allem die zu erzielende Zündspannungshöhe sowie die hohe Temperaturbeständigkeit von Bedeutung.

### Stand der Technik

Die Herstellung eines beschriebenen Spiral-Puls-Generators erfolgt entweder in der LTCC(low temperature cofired ceramic)-Technologie oder in einem weiterentwickelten Verfahren. Die LTCC-Technologie eignet sich zur Herstellung monolithischer keramischer Mehrschichtsysteme mit integrierten passiven Bauelementen (siehe z. B. D. L. Wilcox, Proc. 1997 ISHM Philadelphia, S. 1723). Diese Technologie ist besonders für keramische Bauteile geeignet, in die elektrisch sehr gut leitendes Material wie Gold, Kupfer, Silber oder Aluminium integriert werden soll. Die wesentlichen Verfahrensschritte der LTCC-Technologie sind:

- Herstellung einer einen organischen Binder enthaltenden Keramikgrünfolie, die außerdem noch eine Glaskeramik aufweisen kann.
- Evtl. Erzeugen von Öffnungen in der Keramikgrünfolie, die für Kontaktierungen gedacht sind.
- Befüllen der Öffnungen mit elektrisch leitendem Material.
- Bedrucken der Keramikgrünfolie mit elektrischen Leiterstrukturen.
- Übereinanderstapeln und Laminieren der Keramikgrünfolien zu einem Verbund.
- Sintern des Verbunds zu einem Körper mit monolithischem Vielschichtaufbau.

Durch das Verdichten des keramischen Materials beim Sintervorgang tritt ein Volumenschwund von 10% - 20% auf.

Das LTCC-Verfahren wird bisher nur für Bauteile mit einer ebenen Struktur wie Leiterplatten, Keramikkondensatoren etc. angewandt. Da z.B. ein Transformator aber induktive Eigenschaften hat, ist er gewickelt. Gewickelte Bauteile sind mit den herkömmlichen Verfahren für LTCC--Keramikkörper nicht herstellbar. US 2003/0128082 A1 zeigt ein ähnliches Verfahren*.*

### Aufgabe

Es ist Aufgabe der Erfindung, ein Herstellverfahren anzugeben, mit dem Spiral-Puls-Generatoren in LTCC ähnlicher Bauweise hergestellt werden können. Es ist ebenfalls Aufgabe der Erfindung, einen Spiral-Puls-Generator anzugeben, der mit obengenannten Verfahren hergestellt wird.

Diese Aufgabe wird gelöst durch ein Verfahren mit den Merkmalen des Anspruch 1 und einen Spiral-Puls-Generator mit den Merkmalen des Anspruchs 17.

### Darstellung der Erfindung

Für die Herstellung werden zwei keramische "GrünFolien" mit metallischer Leitpaste bedruckt oder mit einer Metallfolie beschichtet und anschließend versetzt zu einer Spirale aufgewickelt und schließlich zu einem Formkörper laminiert. Alternativ kann auch ein keramischer Schlicker auf eine Metallfolie aufgebracht werden, der Schlicker/Folienverbund getrocknet werden und sodann gewickelt und laminiert werden. Die folgende Co-Sinterung von Metallpaste oder -folie und dem keramischen Material erfolgt an Luft je nach Verfahrensvariante im den Temperaturbereichen 500°C-600°C, 800°C-900°C, 1250°C-1450°C. Diese Verarbeitung erlaubt einen Einsatzbereich des Spiral-Puls-Generators je nach Variante bis 500°C, 700 °C, 1000°C Temperaturbelastung. Dadurch kann der Spiral-Puls-Generator in direkter Nähe des Entladungsgefäßes im Außenkolben einer Gasentladungslampe, aber auch im Sockel oder in unmittelbarer Nähe der Lampe untergebracht werden.

Es ist von Vorteil, wenn für die Herstellung der keramischen Grünfolie beziehungsweise des keramischen Schlickers keramische Stoffsysteme mit hoher Dielektrizitätskonstante oder mit hoher Permeabilität oder eine Mischung aus beiden verwendet werden.

Es ist weiterhin vorteilhaft wenn als Metallfolie eine eloxierte Aluminiumfolie, eine Molybdänfolie oder eine Folie aus einem oder einer Mischung der Metalle Kupfer, Nickel, Stahl, Zink verwendet wird.

Es ist weiterhin vorteilhaft, wenn in einem Herstellverfahren mittels einer Metallfolie das Wickeln des Folienverbundes und das Laminieren des Wickels in einem einzigen Prozessschritt ausgeführt werden. Dabei kann das Wickeln und Laminieren des Folienverbundes über beheizte Rollen erfolgen, die einen definierten Aufpressdruck bei einem definiertem Zug der Folie erzeugen.

Das Sintern des laminierten Wickels erfolgt bevorzugt bei 500°C - 600°C im Falle einer Aluminiumfolie als Metallfolie, bei 800°C - 900°C im Falle einer Metallischen Paste oder einer Folie aus einem oder einer Mischung der Metalle Kupfer, Nickel, Stahl, Zink, sowie bei 1250°C - 1450°C im Falle einer Molybdänfolie.

Das Bedrucken der Keramikgrünfolie mit einer metallischen Paste erfolgt bevorzugt durch ein Ziehverfahren mit einem Rakel mit 10µm - 120µm Spaltbreite bei einer Ziehgeschwindigkeit zwischen 0,5 cm/s bis 2,0 cm/s.

Das Laminieren des Wickels im Falle der metallischen Leitpaste erfolgt bevorzugt durch einen isostatischen Pressprozess bei Badtemperaturen von 30°C bis 80°C, und einer Presszeit zwischen 5 und 15 Minuten.

Weitere vorteilhafte Weiterbildungen und Ausgestaltungen des erfindungsgemäßen Spiral-Puls-Generators beziehungsweise des Herstellverfahrens ergeben sich aus weiteren abhängigen Ansprüchen und aus der folgenden Beschreibung.

### Kurze Beschreibung der Zeichnung(en)

Im Folgenden soll das erfindungsgemäße Verfahren anhand eines Beispiels näher erläutert werden. Die Figuren zeigen:

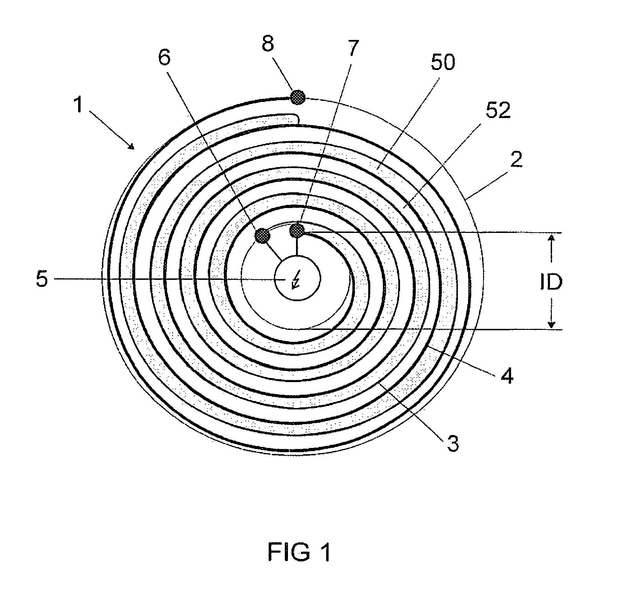

Fig. 1 Den prinzipiellen Aufbau eines Spiral-Puls-Generators.

Fig. 2a-c Den Schnitt durch eine Folienschicht und die weitere Verarbeitung nach der ersten Ausführungsform.

Fig. 3a-b Die Erstellung eines Folienwickels.

Fig. 4a-b Das Auslösen des Wickels nach dem Laminieren.

Fig. 5 Eine Metallhalogenidlampe mit Spiral-Puls-Generator im Außenkolben.

Fig. 6 Eine Metallhalogenidlampe mit Spiral-Puls-Generator im Sockel.

Fig. 7 den Prinzipaufbau einer Natriumhochdrucklampe mit Spiral-Puls-Generator im Außenkolben.

Fig. 8 den Prinzipaufbau einer Metallhalogenidlampe mit Spiral-Puls-Generator im Außenkolben.

Fig. 9a-b Den Schnitt durch eine Folierischicht und die weitere Verarbeitung nach der zweiten Ausführungsform und einer ersten Ausbildung.

Fig. 10 Den Schnitt durch eine Folienschicht nach der zweiten Ausführungsform und einer zweiten Ausbildung.

### Bevorzugte Ausführung der Erfindung

Das erfindungsgemäße Verfahren kann in zwei verschiedenen Varianten ausgeführt werden. Die erste Variante beschreibt ein Herstellungsverfahren, dass dem herkömmlichen LTCC-Verfahren entlehnt ist. Die zweite Variante ist ein weiterentwickeltes Verfahren bei dem die Leitpaste durch eine Leitfähige Metallfolie ersetzt wird.

### Erste Variante des erfindungsgemäßen Verfahrens

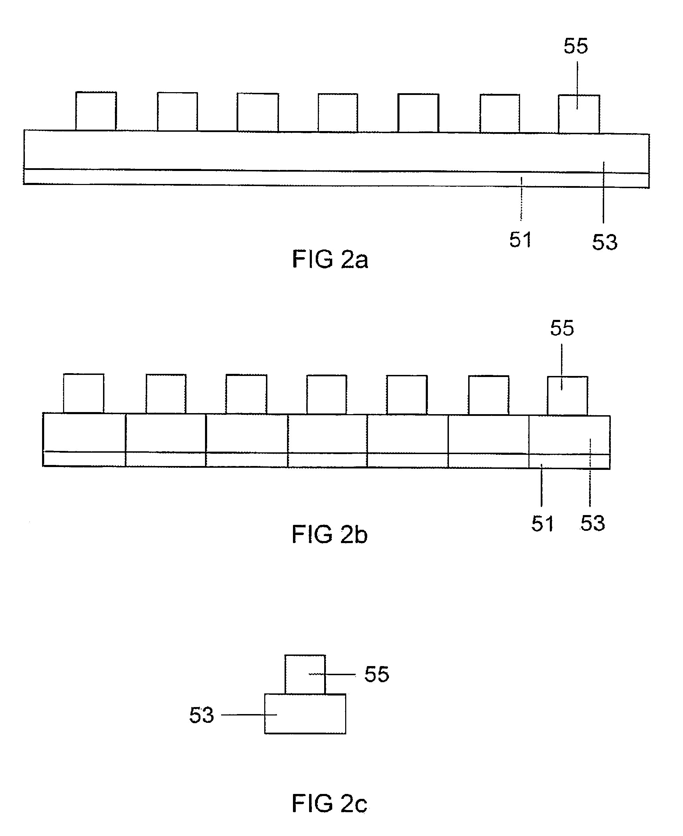

Die Herstellung eines keramischen Spiral-Puls-Generators beginnt wie die Herstellung eines konventionellen LTCC-Substrates mit der Herstellung der Keramikgrünfolien (Fig. 2). Der Schlicker wird auf eine Kunststoffträgerfolie 51 z.B. durch Rakeln aufgebracht und dann getrocknet. Die Kunststoffträgefolie wird dann auf eine ebenen Fläche, z.B. eine Glasplatte, mit einem dünnen Wasserfilm aufgewalzt. Der Wasserfilm fixiert die Folie auf der Glasplatte. Der Schlicker enthält die eigentliche Keramik, ein organisches Bindemittel sowie evtl. ein Glaslot.

Alternativ kann zur Herstellung von Keramikgrünfolien das Foliengießen nach dem Doctor-Blade Verfahren angewandt werden. Dabei wird wie vorher beschrieben aus dem Keramikmaterial und dem Glaslot durch Zugabe von Lösungs- und Dispergiermitteln ein gießfähiger Schlicker hergestellt, der dann mit Hilfe einer Schneide (sog. Doctor-Blade) mit definierter Dicke auf eine umlaufende Folie gegossen wird. Nach dem Trocknen ist die hergestellte Grünfolie plastisch und gut handhabbar. Für den Foliengießprozeß ist ein höherer Gehalt an Binde- und Plastifizierungsmitteln notwendig. Als Faustregel gilt, dass die Keramikpartikelzwischenräume komplett durch diese Zusatzstoffe gefüllt sein müssen, um handhabbare Grünfolien zu erhalten.

Die Keramik kann entweder eine kapazitiv wirkende Keramik mit einem hohen εᵣ oder eine induktiv wirkende Keramik mit hohem µᵣ oder eine Mischung aus beiden sein. Für die Herstellung von Spiral-Puls-Generatoren eignen sich alle keramischen Stoffsysteme, aus denen über einen Schlicker keramische Grünfolien gezogen werden können. Die kapazitiv wirkenden keramischen Stoffsysteme (nichtmetallische anorganische Systeme) besitzen im Grundzustand eine Dielektrizitätskonstante εᵣ zwischen 5 und 20 000). Die induktiv wirkenden Stoffsysteme besitzen im Grundzustand Permeabilitäten µᵣ zwischen 20 und 6000.

Die vorzugsweise verwendeten Stoffsysteme für kapazitiv wirkende Keramiken sind in folgender Tabelle angegeben:

| Material | Chem. Bezeichnung | Dielektrizi tätskonstante |
|---|---|---|
| Keramische Substrate der LTCC-Technologie | BaSrTiO₃, BaNd₂Ti₄O₁₂, BaO-Re₂O₃-TiO₂ (Re = La, Sm, Nd, Eu) | 3-10 000 |
| Bariumtitanate | BaTiO₃ | 10-20 000 |
| Barium-Zirkonat-Titanate | BaZrTiO₃ | ~20000 |
| Blei-Zirkonat-Titanate | BaZrTiO₃ | ~2000 |
| PZT (weich und hart) mit Additiven | ABO₃ (A=La, Ag, B=Nb) | ~9000 |
| Blei-Magnesium-Niobat (PMN) | Pb₃MgNb₂O₉ | ~20 000 |
| Blei-Zink-Niobat (PZN) | Pb₃ZnNb₂O₉ | ~20 000 |
| Kalium-Natrium-Niobate (KNN) | (K, Na)NbO₃ | ~1000 |
| Wismut-basierte Perowskite | BiScO₃ - PbTiO₃ | ~1000 |
| Wolfram-Bronzen | NaₓWO₃ | ~1000 |

Die vorzugsweise verwendeten Stoffsysteme für induktiv wirkende Keramiken sind in folgender Tabelle angegeben:

| Keramischer Ferrit | Permeabilität µᵣ |
|---|---|
| Ba-Hexaferrit | 20-100 |
| NiZnCu-Ferrit | 100-500 |
| MnZn-Ferrit | 200-6000 |

Für die Herstellung der Grünfolien kann die Keramik eines oder mehrere der vorgenannten Stoffsysteme enthalten. Es können auch beliebige Mischungen der vorgenannten Stoffsysteme in der Keramik enthalten sein.

Nach dem Herstellen der Keramikgrünfolie 53 wird diese mit metallischer Leitpaste in Streifen 55 von 3mm-25mm Breite bedruckt, wie in Fig. 2a gezeigt. Die Metallisierung 55 kann mit allen gängigen Verfahren zur Verarbeitung pastöser Massen erfolgen, z.B. mittels Siebdruckverfahren oder mittels eines speziell geformten Rakels. Für die Herstellung von Spiral-Puls-Generatoren ist die Aufbringung mittels Rakel am effizientesten. Der Rakel wird mit einer Spaltbreite von 10µ - 120µ über die Keramikgrünfolie 53 gezogen und so die Leitpaste 55 aufgebracht. Die Ziehgeschwindigkeit beträgt hier etwa zwischen 0,5cm/sec und 2cm/sec.

Nach dem Aufbringen der Leiterbahnen 55 werden diese bei 60°C bis 80°C getrocknet. Die Trocknungszeit beträgt zwischen 5min und 20min. Die Leiterbahnen können auch bei Zimmertemperatur getrocknet werden. Die Trocknungszeit beträgt dann 1-3 Tage.

Nach dem Trocknen wird die Anordnung in Streifen gewünschter Breite geschnitten. Diese in Fig. 2b dargestellten Streifen können noch bei Bedarf mit Aussparungen versehen werden. Diese werden besonders einfach durch Stanzen erzeugt. Andere Verfahren zur Strukturierung von Keramikgrünfolien wie beispielsweise Photolithograpie oder das Erzeugen von Öffnungen mit Hilfe von Laserstrahlung können hier genauso angewendet werden.

Die Grünfolie 53 mit den aufgebrachten Leiterbahnen 55 wird nun von der Trägerfolie 51 abgezogen, wie in Fig. 2c gezeigt.

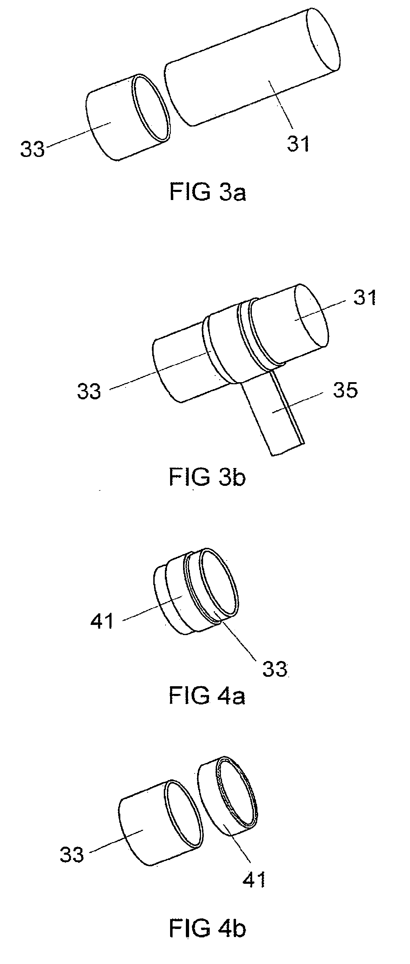

Die Folienstreifen werden auf einen Kunststoffkern gewickelt. Der Kunststoffkern besteht aus einer Kunsstoffhülse 33, die auf einen Kunststoffdorn 31 gesteckt ist (Fig. 3a). Zwei versetzt übereinander liegende Folienstreifen 35 werden nun auf die Hülse aufgewickelt und z.B. mit etwas Wasser fixiert (Fig. 3b). Um die Keramikgrünfolien 35 zu schützen wird um die Anordnung eine mit Trennmittel beschichtetre Gummimatte herumgewickelt. Das Trennmittel kann z.B. Kohlenstoff sein. Die gesamte Anordnung wird nun in Folie eingeschweißt.

Die Folieneinschweißung ist für den nun folgenden Laminationsprozeß notwendig. Zum Laminieren wird der eingeschweißte Grünfolienwickel einem isostatischem Pressprozess unterzogen. Die Presszeiten liegen zwischen 5 und 15 Minuten, die Badtemperatur zwischen 30°C und 80°C.

Nach dem Laminationsprozess kann die Hülse vom Kern abgezogen werden (Fig. 4a). Durch das isostatische Pressen ist der laminierte Wickel 41 so widerstandsfähig geworden, dass die Kunststoffhülse 33 vom Wickel 41 getrennt werden kann (Fig. 4b), ohne den Formkörper dabei zu beschädigen.

Anschließend wird der Wickel 41 bei Temperaturen zwischen 600°C und 900°C co-gesintert. Dieser Prozess gleicht wieder dem normalen LTCC-Herstellprozeß. Auch hier tritt durch das Sintern eine Verdichtung des Materials und damit eine Schwindung zwischen 10% und 20% des Volumens ein.

Ein solcherart hergestellter Spiral-Puls-Generator erlaubt einen Einsatz für die Zündung von Gasentladungslampen für Temperaturen bis ca. 700° bei einer Zündspannung von mehr als 1,5kV.

Da das LTCC-Verfahren für eine Integration passiver Bauelemente geeignet ist, kann in den Spiral-Puls-Generator gleich ein Ladewiderstand mit integriert werden. Dieser ist zum Betrieb des Spiral-Puls-Generators notwendig. Die Einbringung eines Ladewiderstandes erfolgt über das LTCC-übliche Verfahren.

### Zweite Variante des erfindungsgemäßen Verfahrens

Die zweite Variante des erfindungsgemäßen Verfahrens unterscheidet sich in einigen Schritten von der ersten Variante. Es werden im folgenden nur die zum ersten Verfahren abweichenden Schritte und Prozesse erläutert.

Die zweite Variante des erfindungsgemäßen Verfahrens ist eine Weiterentwicklung der ersten Variante und für die maschinelle Verarbeitung geeignet. Die zweite Variante ist gegenüber der ersten Variante auch auf der Kostenseite im Vorteil, da günstigere Materialien eingesetzt werden.

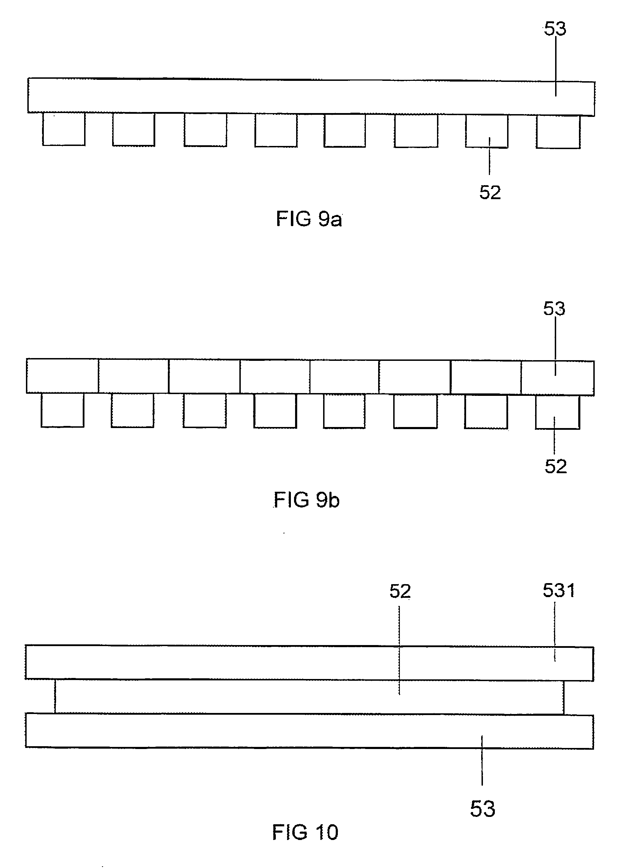

In der zweiten Variante des erfindungsgemäßen Verfahrens besteht die Leiterstruktur aus einer Metallfolie 52. Dies hat gegenüber der ersten Variante zwei Vorteile. In der zweiten Variante wird die Metallfolie 52 zum Teil auch gleichzeitig als Trägerfolie verwendet und stützt nach dem Laminieren die Keramikgrünfolie 53, die aufgrund ihrer Dicke (40µ - 60µ) mechanisch sehr schwierig zu verarbeiten ist (Fig. 9a). Die für das Verfahren verwendeten Metallfolien sind aufgrund des Verwendeten Metalls (vorzugsweise Aluminium oder Molybdän) deutlich kostengünstiger als die Leitpasten, die vorwiegend aus Edelmetallen aufgebaut sind.

Im ersten Arbeitsgang werden auch hier keramische Grünfolien 53 erzeugt, die aber gegenüber dem ersten Verfahren ein niedriger schmelzendes Glaslot (Bei Aluminiumfolie) beziehungsweise höher schmelzendes Glaslot (Bei Molybdänfolie) enthalten. Ansonsten können die gleichen Stoffsysteme und Mischungen daraus, wie in der ersten Variante des Verfahrens beschrieben, zum Einsatz kommen. Dieser Prozess kann und sollte kontinuierlich ablaufen. Ist die Keramikgrünfolie 53 auf einem Kunststoffträger erzeugt worden, so wird sie im zweiten Schritt in einem weiteren kontinuierlichen Prozess auf die Metallfolie(n) 52 auflaminiert. Die Metallfolie ist vorzugsweise eine eloxierte Aluminiumfolie oder eine Molybdänfolie. Die Eloxierung (Al₂O₃) bewirkt eine ausgezeichnete Haftung zwischen Keramikgrünfolie und Aluminiumfolie. Die Molybdänfolie bietet den Vorteil einer höheren Temperaturbelastbarkeit, da der Spiral-Puls-Generator bei 1250°C-1450°C gesintert wird. Das Laminieren kann hier durch Aufwalzen mit beheizten Rollen und einem entsprechenden Aufpressdruck erfolgen.

Nach der Lamination kann der Folienverbund auf die gewünschte Breite beschnitten werden, wie in Fig. 9b dargestellt. Es kann aber auch von Anfang an eine Keramikgrünfolie und eine Metallfolie in der gewünschten Breite verwendet werden.

In einer zweiten Ausbildung wird die Metallfolie 52 beidseitig mit einer Keramikgrünfolie 53, 531 beschichtet, wie in Fig. 10 dargestellt. Die keramischen Grünfolien können verschiedene Eigenschaften haben, z.B. kann eine Folie 53 eine hohe Permittivität und die andere Folie eine hohe Permeabilität aufweisen. Beim Wickeln ergibt sich zwischen den Metalllagen ein Doppelschichtaufbau, der die Eigenschaften beider Folien aufweist.

Sobald der Laminationsprozess abgeschlossen ist, übernimmt die Metallfolie die Tragfestigkeit des Verbundes. Die mechanische Stabilität des Verbundes ist ausreichend, um ihn im weiteren Verlauf maschinell verarbeiten zu können.

Der Folienverbund wird nun vorzugsweise maschinell gewickelt. Zum Wickeln werden zwei der beschichteten Bänder versetzt übereinander gelegt und zu einem Spiral-Puls-Generator aufgewickelt. Nach dem Wickeln wird der noch grüne Spiral-Puls-Generator laminiert. Das Laminieren kann aber auch direkt beim Wickeln stattfinden. Dabei entfällt natürlich der vorhergehende Laminationsprozess. Vorzugsweise werden hier wieder beheizte Rollen mit einem definierten Aufpressdruck verwendet. Beim Wickeln wird natürlich ebenso ein definierter Zug des Folienverbundes eingehalten. Diese beiden Parameter zusammen mit der Rollentemperatur gewährleisten eine gleichbleibende und gute Lamination des Spiral-Puls-Generators. Das Wickeln kann mittels einer Hülse 33 stattfinden, es ist aber auch möglich, den Spiral-Puls-Generator ohne Hülse zu wickeln.

Dann kann der gewickelte Generator gesintert werden. Das Sintern erfolgt bei Verwendung einer Aluminiumfolie bei einer niedrigeren Temperatur von 500°C bis 600°C. Dies ist notwendig, um deutlich unter der Schmelztemperatur der Metallfolie zu bleiben. Durch die eloxierte Oberfläche des Aluminiumbandes (Al₂O₃) ergibt sich ein besonders fester Metall/Keramik Verbund. Bei einer Metallfolie aus einem oder einer Mischung der Metalle Kupfer, Nickel, Stahl, Zink wird der gewickelte Generator bei einer Temperatur von 800°C - 900°C gesintert. Wird die Molybdänfolie verwendet, so erfolgt das Sintern bei einer Temperatur von 1250°C-1450°C unter Schutzgasatmosphäre (Ar, N₂, Formiergas).

Durch die zweite Variante des erfindungsgemäßen Verfahrens können Spiral-Puls-Generatoren in großen Stückzahlen kostengünstig gefertigt werden. Durch die Reduzierung der Sintertemperaturen, den Ersatz der Edelmetallpasten durch kostengünstige, kommerziell erhältliche Metallfolien und die maschinelle Verarbeitung können Spiral-Puls-Generatoren in Anwendungsbereiche vordringen, die ihnen bisher aus Kostengründen vorenthalten waren.

### Dritte Variante des erfindungsgemäßen Verfahrens

Die dritte Variante des erfindungsgemäßen Verfahrens unterscheidet sich nur unwesentlich von der zweiten Variante. Es werden daher nur die von der zweiten Variante abweichenden Verfahrensschritte erläutert.

Bei der dritten Variante des erfindungsgemäßen Verfahrens wird keine keramische Grünfolie mehr hergestellt, die dann weiterverarbeitet wird. Die Grünfolienherstellung wird vielmehr direkt in den Fertigungsprozess des Spiral-Puls-Generators integriert. Somit entfällt der erste Schritt der Herstellung der keramischen Grünfolien, er wird mit dem zweiten Schritt vereint. Anstatt die vorher hergestellten Grünfolien auf die Metallfolie zu laminieren wird die Metallfolie direkt mit dem keramischen Schlicker beschichtet und dann getrocknet. Dadurch entfällt ein aufwendiger Arbeitsgang und die heikle Handhabung der keramischen Grünfolien. Dieser Prozess kann auch als kontinuierlicher Prozess ausgelegt sein.

Die Beschichtung kann mittels eines tape-cast-Verfahrens oder mit einem Rakel bewerkstelligt werden. Bevorzugt wird die Beschichtung mittels eines Tauchverfahrens durchgeführt. Dabei wird die Metallfolie durch ein Bad, das den keramischen Schlicker enthält, geführt. Dabei bildet sich auf der Oberfläche der Metallfolie eine Schicht des keramischen Schlickers. Da die Metallfolie komplett von dem keramischen Schlicker umhüllt ist, muss die Schichtdicke nur die Hälfte der gewünschten Schichtdicke betragen, da beim Zusammenwickeln zweier beschichteter Metallfolien zu einem Spiral-Puls-Generator jeweils zwei keramische Schichten zwischen den Metallfolien übereinander zu liegen kommen.

Um die kapazitiven und induktiven Eigenschaften des Spiral-Puls-Generators möglichst frei einstellen zu können kann auch ein mehrschichtiger Aufbau der keramikschicht angestrebt werden. Dazu wird die Metallfolie mehrmals hintereinander durch ein Bad mit einem keramischen Schlicker gezogen, wobei die keramischen Schlicker verschiedene Eigenschaften haben können. Es ist z.B. von Vorteil, wenn eine induktive Schicht, die elektrisch leitend ist, von zwei gut isolierenden kapazitiven Schichten umschlossen ist. Dadurch werden Kriechströme bei einem fertig gewickelten und aufgeladenen Spiral-Puls-Generator unterbunden.

Dazu wird die Metallfolie erst durch ein Bad mit kapazitiv wirkendem Schlicker gezogen, dann durch ein Bad mit induktiv wirkenden Schlicker und abschließend wieder durch ein Bad mit kapazitiv wirkendem Schlicker. Das Bad muss dabei so beschaffen sein, dass die abgeschiedenen Schichtdicken zusammen die gewünschte Schichtdicke ergeben. Im einfachsten Fall ist hierbei die abgeschiedene Schichtdicke ein Drittel der gewünschten Schichtdicke für eine Folie. Es ist aber auch denkbar, dass die kapazitiv wirkenden Schichten und die induktiv wirkenden Schichten unterschiedliche Stärken besitzen.

Da sich die Schichtdicke zweier Folien aufaddieren, ist es auch denkbar, dass solch ein beispielhafter dreilagiger Aufbau mittels der Schichten beider Metallfolien bewerkstelligt wird. Dabei wird z.B. auf einer Metallfolie eine kapazitive und eine Induktive Schicht aufgebracht. Auf der anderen Folie wird eine kapazitive Schicht appliziert. Werden die Folien zusammengewickelt, ergibt sich der gewünschte dreilagige Aufbau aus kapazitiver-induktiver-kapazitiver Schicht. Die Gesamtschichtdicke auf der ersten Folie kann dabei doppelt so stark sein wie die Schicht auf der zweiten Folie, so dass sich insgesamt eine gleichmäßige Schichtdickenverteilung ergibt. Die Schichtdicken können aber auch je nach den Anforderungen variiert werden.

Die abgeschiedene Schichtdicke kann über die Schlickerzusammensetzung, deren Viskosität und deren Temperatur eingestellt werden.

Eine typische Schlickerzusammensetzung für die einlagige Beschichtung einer Metallfolie stellt sich wie folgt dar:

| Menge | Material |
|---|---|
| 100g | Keramiches Pulvere (Dielektrikum, Ferrit) |
| 20g- 40g | Lösungsmittel (Ethanol, Tulol, Wasser, Methyl-Ethyl-Keton) |
| 2g-4g | Dispergator (z.B. KD 1-4, Fa. ICI) |
| 30g- 45g | Binderlösung (Polyvinylbuthyral (PVB), Acrylatbinder, Epoxidbasierte Binder, Polypropylencarbonat, Methylcellulose, Polyvinylalkohol (PVA)) |
| 2g-5g | Weichmacher (Phtalate, z.B. Benzylbutylphtalat) |

Der Viskositätsbereich des Schlickers sollte dabei zwischen 10mPa*s und 900mPa*s liegen, bei einer Temperatur von 20°C-40°C

Dabei ist die mittlere Korngröße des keramischen Pulvers vorteilhaft zwischen 500nm und 10 µm groß.

Um die Haftung des Schlickers auf der Metallfolie zu Verbessern, kann diese zunächst mit einer haftvermittelnden Schicht versehen werden. Bei einer Aluminiumfolie kann z.B. eine AL₂O₃ Schicht aufgebracht werden, an der der keramische Schlicker sehr gut haftet.

Nach Trocknung wird der Metall/Grünfolienverbund wie in der zweiten Ausführungsvariante gewickelt und dann laminiert beziehungsweise beim Wickeln laminiert. Dabei gelten dieselben Vorraussetzungen wie in der zweiten Variante. Die weitere Verarbeitung unterscheidet sich nicht von der zweiten Variante.

### Anwendungsvarianten

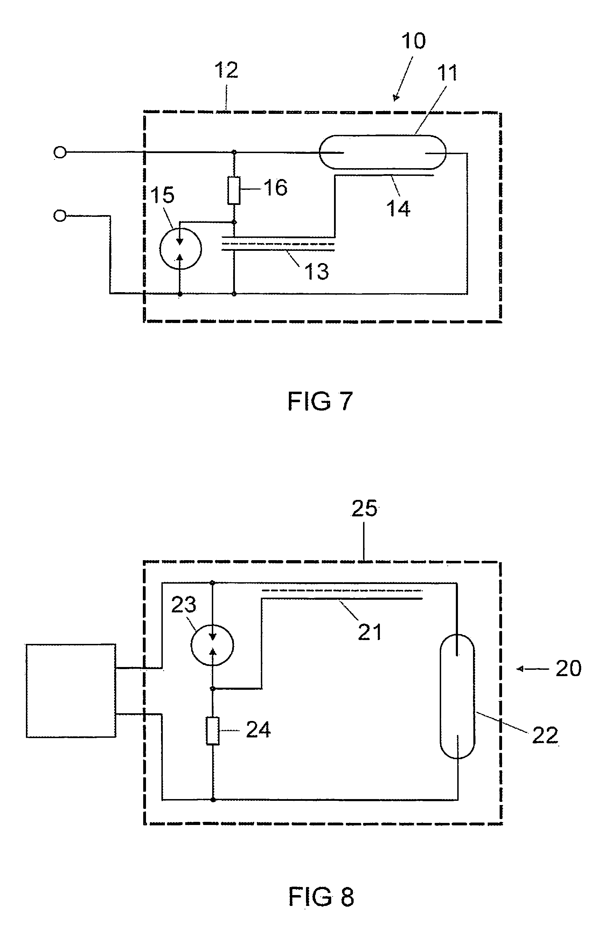

Figur 7 zeigt den prinzipiellen Aufbau einer Natriumhochdrucklampe 10 mit keramischem Entladungsgefäß 11 und Außenkolben 12 mit darin integriertem Spiral-Puls-Generator 13, wobei eine Zünd-Elektrode 14 außen am keramischen Entladungsgefäß 11 angebracht ist. Der Spiral-Puls-Generator 13 ist mit der Funkenstrecke 15 und dem Ladewiderstand 16 im Außenkolben untergebracht.

Figur 8 zeigt den prinzipiellen Aufbau einer Metallhalogenidlampe 20 mit integriertem Spiral-Puls-Generator 21, wobei keine Zünd-Elektrode außen am Entladungsgefäß 22, das aus Quarzglas oder Keramik gefertigt sein kann, angebracht ist. Der Spiral-Puls-Generator 21 ist mit der Funkenstrecke 23 und dem Ladewiderstand 24 im Außenkolben 25 untergebracht.

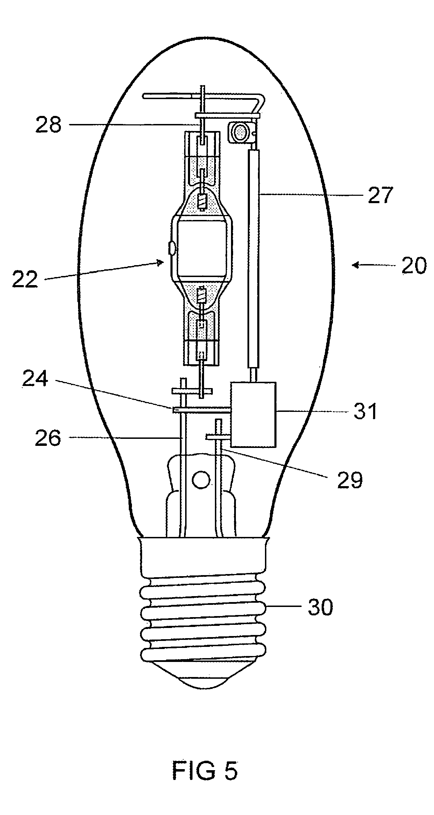

Figur 5 zeigt eine Metallhalogenidlampe 20 mit einem Entladungsgefäß 22, das von zwei Zuleitungen 26, 27 in einem Außenkolben gehaltert wird. Die erste Zuleitung 26 ist ein kurz abgewinkelter Draht. Die zweite 27 ist im wesentlichen ein Stab, der zur sockelfernen Durchführung 28 führt. Zwischen der Zuleitung 29 aus dem Sockel 30 und dem Stab 27 ist eine Zündeinheit 31 angeordnet, die den Spiral-Puls-Generator, die Funkenstrecke und den Ladewiderstand enthält, wie in Figur 4 angedeutet.

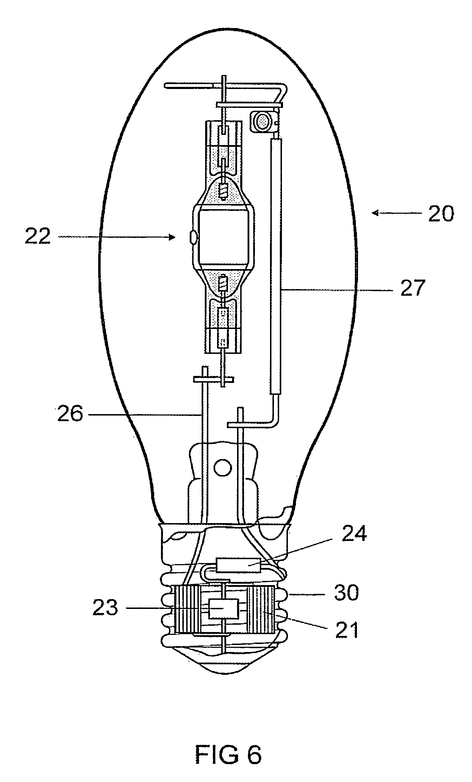

Figur 6 zeigt eine Metallhalogenidlampe 20 ähnlich wie Figur 5 mit einem Entladungsgefäß 22, welches von zwei Zuleitungen 26, 27 in einem Außenkolben 25 gehaltert wird. Die erste Zuleitung 26 ist ein kurz abgewinkelter Draht. Die zweite 27 ist im Wesentlichen ein Stab, der zur sockelfernen Durchführung 28 führt. Hier ist die Zündeinheit im Sockel 30 angeordnet, und zwar sowohl der Spiral-Puls-Generator 21, als auch die Funkenstrecke 23 und der Ladewiderstand 24.

Diese Technik kann auch für elektrodenlose Lampen angewendet werden, wobei der Spiral-Puls-Generator als Zündhilfe dienen kann.

Weitere Anwendungen dieses kompakten Hochspannungspulsgenerators liegen in der Zündung anderer Geräte. Die Anwendung ist vor allem bei sog. magischen Kugeln, bei der Erzeugung von Röntgenpulsen und der Erzeugung von Elektronenstrahl-Pulsen vorteilhaft. Auch ein Einsatz in. Kfz als Ersatz für die üblichen Zündspulen ist möglich.

Dabei werden Windungszahlen n von bis zu 500 verwendet, so dass die Ausgangsspannung die Größenordnung von 100 kV erreicht. Denn die Ausgangsspannung UA ist als Funktion der Ladespannung UL gegeben durch UA = 2 x n x UL x η, wobei die Effizienz η durch η = (AD-ID)/AD gegeben ist.

Die Erfindung entfaltet besondere Vorteile im Zusammenwirken mit Hochdruckentladungslampen für Autoscheinwerfer, die mit Xenon unter hohem Druck von bevorzugt mindestens 3 bar und Metallhalogeniden gefüllt sind. Diese sind besonders schwer zu zünden, da wegen des hohen Xenondrucks die Zündspannung mehr als 10 kV beträgt. Der Spiralpulsgenerator kann im Sockel der Lampe oder in einen Außenkolben der Lampe angeordnet sein.

Die Erfindung entfaltet ganz besondere Vorteile im Zusammenwirken mit Hochdruckentladungslampen, die kein Quecksilber enthalten. Derartige Lampen sind aus Umweltschutzgründen besonders erstrebenswert. Sie enthalten eine geeignete Metallhalogenid-Füllung und insbesondere ein Edelgas wie Xenon unter hohem Druck. Wegen des fehlenden Quecksilbers ist die Zündspannung besonders hoch. Sie beträgt mehr als 20 kV. Auch hier kann ein Spiralpulsgenerator mit integriertem Ladewiderstand entweder in den Sockel der Quecksilberfreien Lampe oder in einen Außenkolben der Lampe untergebracht sein.

## Patentansprüche

1. Verfahren zur Herstellung eines keramischen Spiral-Puls-Generators **gekennzeichnet durch folgende Verfahrensschritte:**
a) Bereitstellen eines Folienverbundes aus mindestens einer Keramikgrünfolie und mindestens einer metallischen Schicht.
b) Wickeln des Folienverbundes zu einem spiralförmig gewickelten Wickel
c) Laminieren des Wickels
d) Sintern des laminierten Wickels, so dass ein Spiral-Puls-Generator entsteht.

2. Verfahren zur Herstellung eines keramischen Spiral-Puls-Generators nach Anspruch 1, **dadurch gekennzeichnet, dass** die Herstellung des Folienverbundes folgende Schritte umfasst:
- Herstellen einer Keramikgrünfolie (53)
- Bedrucken der Keramikgrünfolie mit einer metallischen Paste
- Beschneiden der bedruckten Keramikgrünfolie

3. Verfahren zur Herstellung eines keramischen Spiral-Puls-Generators nach Anspruch 1, **dadurch gekennzeichnet, dass** die Herstellung des Folienverbundes folgende Schritte umfasst:
- Herstellen einer Keramikgrünfolie (53)
- Auflaminieren der Keramikgrünfolie (53) auf eine Metallfolie (52)

4. Verfahren zur Herstellung eines keramischen Spiral-Puls-Generators nach Anspruch 1, **dadurch gekennzeichnet, dass** die Herstellung des Folienverbundes folgende Schritte umfasst:
- Beschichten einer Metallfolie (52) mit einem keramischen Schlicker
- Trocknen des Verbundes aus dem keramischen Schlicker und der Metallfolie

5. Verfahren zur Herstellung eines keramischen Spiral-Puls-Generators nach Anspruch 4, **dadurch gekennzeichnet, dass** das Beschichten durch ein Tauchbeschichtungsverfahren durchgeführt wird, bei dem die Metallfolie (52) in ein Bad aus keramischen Schlicker eingetaucht wird.

6. Verfahren zur Herstellung eines keramischen Spiral-Puls-Generators nach einem der vorhergehenden Ansprüche , **dadurch gekennzeichnet, dass** für die Herstellung der keramischen Grünfolie (53) beziehungsweise des keramischen Schlickers keramische Stoffsysteme mit hoher Dielektrizitätskonstante oder mit hoher Permeabilität oder eine Mischung aus beiden verwendet werden.

7. Verfahren zur Herstellung eines keramischen Spiral-Puls-Generators nach einem der Ansprüche 3 oder 4, **dadurch gekennzeichnet, dass** die Metallfolie eine eloxierte Aluminiumfolie ist.

8. Verfahren zur Herstellung eines keramischen Spiral-Puls-Generators nach einem der Ansprüche 3 oder 4, **dadurch gekennzeichnet, dass** die Metallfolie eine Molybdänfolie ist.

9. Verfahren zur Herstellung eines keramischen Spiral-Puls-Generators nach einem der Ansprüche 3 oder 4, **dadurch gekennzeichnet, dass** die Metallfolie wenigstens eines der Metalle aus der Gruppe Kupfer, Nickel, Stahl, Zink beinhaltet.

10. Verfahren zur Herstellung eines keramischen Spiral-Puls-Generators nach Anspruch 1, **dadurch gekennzeichnet, dass** die Schritte b (Wickeln des Folienverbundes) und c (Laminieren des Wickels) in einem einzigen Prozessschritt ausgeführt werden.

11. Verfahren zur Herstellung eines keramischen Spiral-Puls-Generators nach Anspruch 10, **dadurch gekennzeichnet, dass** das Wickeln und Laminieren des Folienverbundes über beheizte Rollen erfolgt, die einen definierten Aufpressdruck bei einem definiertem Zug der Folie erzeugen.

12. Verfahren zur Herstellung eines keramischen Spiral-Puls-Generators nach Anspruch 2, **dadurch gekennzeichnet, dass** das Bedrucken der Keramikgrünfolie mit einer metallischen Paste durch ein Ziehverfahren mit einem Rakel mit 10µm - 120µm Spaltbreite bei einer Ziehgeschwindigkeit zwischen 0,5 cm/s bis 2,0 cm/s erfolgt.

13. Verfahren zur Herstellung eines keramischen Spiral-Puls-Generators nach Anspruch 1, **dadurch gekennzeichnet, dass** das Laminieren des Wickels durch einen isostatischen Pressprozess bei Badtemperaturen von 30°C bis 80°C und bei einer Presszeit zwischen 5 und 15 Minuten erfolgt.

14. Verfahren zur Herstellung eines keramischen Spiral-Puls-Generators nach Anspruch 1, **dadurch gekennzeichnet, dass** das Sintern des laminierten Wickels bei 500°C - 600°C erfolgt.

15. Verfahren zur Herstellung eines keramischen Spiral-Puls-Generators nach Anspruch 1, **dadurch gekennzeichnet, dass** das Sintern des laminierten Wickels bei 1250°C - 1450°C erfolgt.

16. Verfahren zur Herstellung eines keramischen Spiral-Puls-Generators nach Anspruch 1, **dadurch gekennzeichnet, dass** das Sintern des laminierten Wickels bei 800°C - 900°C erfolgt.

17. Spiral-Puls-Generator, der durch ein Verfahren nach den Ansprüchen 1-16 hergestellt wird.

18. Verwendung eines Spiral-Puls-Generators in einer Hochdruckentladungslampe mit einem Entladungsgefäß, das in einem Außenkolben der Hochdruckentladungslampe untergebracht ist und dort durch ein Gestell gehaltert ist, wobei eine Zündvorrichtung in der Hochdruckentladungslampe integriert ist, die Hochspannungspulse in der Hochdruckentladungslampe erzeugt, und die Zündvorrichtung ein Spiral-Puls-Generator nach Anspruch 17 ist, der Teil des Gestells und im Außenkolben der Hochdruckentladungslampe untergebracht ist.

## Claims

1. Method for producing a ceramic spiral pulse generator, **characterized by** the following method steps:
a) providing a film composite comprising at least one ceramic green film and at least one metal layer
b) winding the film composite to form a spirally wound winding
c) laminating the winding
d) sintering the laminated winding so as to create a spiral pulse generator.

2. Method for producing a ceramic spiral pulse generator as claimed in Claim 1, **characterized in that** the production of the film composite comprises the following steps:
- producing a ceramic green film (53)
- printing on the ceramic green film with a metallic paste
- cutting the printed ceramic green film.

3. Method for producing a ceramic spiral pulse generator as claimed in Claim 1, **characterized in that** the production of the film composite comprises the following steps:
- producing a ceramic green film (53)
- laminating the ceramic green film (53) onto a metal foil (52).

4. Method for producing a ceramic spiral pulse generator as claimed in Claim 1, **characterized in that** the production of the film composite comprises the following steps:
- coating a metal foil (52) with a ceramic slurry
- drying the composite comprising the ceramic slurry and the metal foil.

5. Method for producing a ceramic spiral pulse generator as claimed in Claim 4, **characterized in that** the coating is carried out by a dip coating method, in which the metal foil (52) is immersed in a bath of ceramic slurry.

6. Method for producing a ceramic spiral pulse generator as claimed in one of the preceding claims, **characterized in that** ceramic material systems with a high dielectric constant or with a high permeability, or a mixture of the two, are used for the production of the ceramic green film (53) or the ceramic slurry.

7. Method for producing a ceramic spiral pulse generator as claimed in one of Claims 3 and 4, **characterized in that** the metal foil is an anodized aluminum foil.

8. Method for producing a ceramic spiral pulse generator as claimed in one of Claims 3 and 4, **characterized in that** the metal foil is a molybdenum foil.

9. Method for producing a ceramic spiral pulse generator as claimed in one of Claims 3 and 4, **characterized in that** the metal foil contains at least one of the metals in the group copper, nickel, steel, zinc.

10. Method for producing a ceramic spiral pulse generator as claimed in Claim 1, **characterized in that** steps b (winding the film composite) and c (laminating the winding) are carried out in a single process step.

11. Method for producing a ceramic spiral pulse generator as claimed in Claim 10, **characterized in that** the winding and laminating of the film composite is carried out by means of heated rollers, which generate a defined application pressure with a defined tension of the film.

12. Method for producing a ceramic spiral pulse generator as claimed in Claim 2, **characterized in that** the ceramic green film is printed on with a metallic paste by a drawing method with a squeegee with a gap width of 10 µm - 120 µm at a drawing speed of between 0.5 cm/s and 2.0 cm/s.

13. Method for producing a ceramic spiral pulse generator as claimed in Claim 1, **characterized in that** the lamination of the winding is carried out by an isostatic pressing process with bath temperatures of from 30°C to 80 °C and with a pressing time of between 5 and 15 minutes.

14. Method for producing a ceramic spiral pulse generator as claimed in Claim 1, **characterized in that** the sintering of the laminated winding is carried out at 500°C - 600°C.

15. Method for producing a ceramic spiral pulse generator as claimed in Claim 1, **characterized in that** the sintering of the laminated winding is carried out at 1250°C - 1450°C.

16. Method for producing a ceramic spiral pulse generator as claimed in Claim 1, **characterized in that** the sintering of the laminated winding is carried out at 800°C - 900°C.

17. Spiral pulse generator which is produced by a method as claimed in Claims 1-16.

18. Use of a spiral pulse generator in a high-pressure discharge lamp having a discharge vessel, which is fitted in an outer bulb of the high-pressure discharge lamp and is held there by a frame, an ignition device which generates high-voltage pulses in the high-pressure discharge lamp being integrated in the high-pressure discharge lamp and the ignition device being a spiral pulse generator as claimed in Claim 17, which is part of the frame and is fitted in the outer bulb of the high-pressure discharge lamp.

## Revendications

1. Procédé de fabrication d'un générateur d'impulsions céramique en spirale **caractérisé par les étapes de procédé suivantes :**
a) préparation d'un assemblage de feuilles constitué d'au moins une feuille céramique verte et d'au moins une couche métallique,
b) enroulement de l'assemblage de feuilles en une bobine enroulée en forme de spirale,
c) laminage de la bobine,
d) frittage de la bobine laminée de manière à obtenir un générateur d'impulsions en spirale.

2. Procédé de fabrication d'un générateur d'impulsions céramique en spirale selon la revendication 1, **caractérisé en ce que** la fabrication de l'assemblage de feuilles comprend les étapes suivantes :
- fabrication d'une feuille céramique verte (53)
- impression de la feuille céramique verte à l'aide d'une pâte métallique
- découpe de la feuille céramique verte imprimée.

3. Procédé de fabrication d'un générateur d'impulsions céramique en spirale selon la revendication 1, **caractérisé en ce que** la fabrication de l'assemblage de feuilles comprend les étapes suivantes :
- fabrication d'une feuille céramique verte (53)
- laminage de la feuille céramique verte (53) sur une feuille métallique (52).

4. Procédé de fabrication d'un générateur d'impulsions céramique en spirale selon la revendication 1, **caractérisé en ce que** la fabrication de l'assemblage de feuilles comprend les étapes suivantes :
- enduction d'une feuille métallique (52) à l'aide d'une barbotine céramique,
- séchage de la matière composite constituée de la barbotine céramique et de la feuille métallique.

5. Procédé de fabrication d'un générateur d'impulsions céramique en spirale selon la revendication 4, **caractérisé en ce que** l'enduction est réalisée au moyen d'un procédé d'enduction au trempé, dans lequel la feuille métallique (52) est plongée dans un bain de barbotine céramique.

6. Procédé de fabrication d'un générateur d'impulsions céramique en spirale selon l'une quelconque des revendications précédentes, **caractérisé en ce que** pour la fabrication de la feuille verte céramique (53) respectivement de la barbotine céramique, on utilise des systèmes de matières céramiques à haute constante diélectrique ou à haute perméabilité ou un mélange des deux.

7. Procédé de fabrication d'un générateur d'impulsions céramique en spirale selon l'une quelconque des revendications 3 ou 4, **caractérisé en ce que** la feuille métallique est une feuille d'aluminium anodisée.

8. Procédé de fabrication d'un générateur d'impulsions céramique en spirale selon l'une quelconque des revendications 3 ou 4, **caractérisé en ce que** la feuille métallique est une feuille de molybdène.

9. Procédé de fabrication d'un générateur d'impulsions céramique en spirale selon l'une quelconque des revendications 3 ou 4, **caractérisé en ce que** la feuille métallique contient au moins un des métaux du groupe cuivre, nickel, acier, zinc.

10. Procédé de fabrication d'un générateur d'impulsions céramique en spirale selon la revendication 1, **caractérisé en ce que** les étapes b (enroulement de l'assemblage de feuilles) et c (laminage de la bobine) sont réalisées en une seule étape de processus.

11. Procédé de fabrication d'un générateur d'impulsions céramique en spirale selon la revendication 10, **caractérisé en ce que** l'enroulement et le laminage de l'assemblage de feuilles sont réalisés au moyen de rouleaux chauffés qui génèrent une pression de compression définie avec une traction définie de la feuille.

12. Procédé de fabrication d'un générateur d'impulsions céramique en spirale selon la revendication 2, **caractérisé en ce que** l'impression de la feuille céramique verte est réalisée à l'aide d'une pâte métallique au moyen d'un procédé de tirage avec une raclette de 10 µm à 120 µm de largeur d'espace à une vitesse de tirage comprise entre 0,5 cm/s et 2,0 cm/s.

13. Procédé de fabrication d'un générateur d'impulsions céramique en spirale selon la revendication 1, **caractérisé en ce que** le laminage de la bobine est réalisé au moyen d'un processus de compression isostatique à des températures de bain de 30°C à 80°C et avec un temps de compression compris entre 5 et 15 minutes.

14. Procédé de fabrication d'un générateur d'impulsions céramique en spirale selon la revendication 1, **caractérisé en ce que** le frittage de la bobine laminée est réalisé à 500°C - 600°C.

15. Procédé de fabrication d'un générateur d'impulsions céramique en spirale selon la revendication 1, **caractérisé en ce que** le frittage de la bobine laminée est réalisé à 1250°C - 1450°C.

16. Procédé de fabrication d'un générateur d'impulsions céramique en spirale selon la revendication 1, **caractérisé en ce que** le frittage de la bobine laminée est réalisé à 800°C - 900°C.

17. Générateur d'impulsions en spirale qui est fabriqué au moyen d'un procédé selon les revendications 1 à 16.

18. Utilisation d'un générateur d'impulsions en spirale dans une lampe à décharge à haute pression comprenant un récipient de décharge qui est logé dans une ampoule extérieure de la lampe à décharge à haute pression et y est maintenu au moyen d'un support, un dispositif d'allumage étant intégré dans la lampe à décharge à haute pression, lequel génère des impulsions à haute tension dans la lampe à décharge à haute pression, et le dispositif d'allumage étant un générateur d'impulsions en spirale selon la revendication 17, qui fait partie du support et est logé dans l'ampoule extérieure de la lampe à décharge à haute pression.
